Europäisches Patentamt

European Patent Office

Office européen des brevets

(19)

(11) Numéro de publication: **0 035 419**
**B1**

(12) # FASCICULE DE BREVET EUROPEEN

(45) Date de publication du fascicule du brevet:
**23.04.86**

(21) Numéro de dépôt: **81400166.5**

(22) Date de dépôt: **03.02.81**

(51) Int. Cl.⁴: **G 03 F 7/08**

(54) Composition photopolymérisable à base de fluoroborate de paradiazo-diphénylamine et de résine époxy liquide, et matériau photosensible la comprenant.

(30) Priorité: **11.02.80 FR 8002966**

(43) Date de publication de la demande:
**09.09.81 Bulletin 81/36**

(45) Mention de la délivrance du brevet:
**23.04.86 Bulletin 86/17**

(84) Etats contractants désignés:
**AT BE CH DE FR GB IT LI LU NL SE**

(56) Documents cités:
**FR - A - 2 101 639**
**NL - A - 7 410 806**
**US - A - 3 205 157**
**US - A - 3 794 576**
**US - A - 3 930 856**
**US - A - 3 936 557**
**US - A - 4 054 639**

**DERWENT JAPANESE PATENTS REPORT, vol. 74, no. 32, publié le 12-09-1974, section G, page 3 London, GB "Novolak resin and borone fluoride diazonium salt" Encyclopedia of Polymer Science and Technology, vol. 3, p. 621**

**Le dossier contient des informations techniques présentées postérieurement au dépôt de la demande et ne figurant pas dans le présent fascicule.**

(73) Titulaire: **RHONE-POULENC SYSTEMES, 39, boulevard des Bouvets, F-92000 Nanterre (FR)**

(72) Inventeur: **Pigeon, Marcel, 66, rue de Longchamp, F-92200 Neuilly/S/Seine (FR)**
Inventeur: **Szretter, Marta, 72, quai Maréchal Joffre, F-92400 Courbevoie (FR)**
Inventeur: **Perie, Chantal, 71, rue Championnet, F-75008 Paris (FR)**

(74) Mandataire: **Chichery, Guy et al, RHONE-POULENC RECHERCHES Service Brevets Chimie et Polymères Centre de Recherches de Saint-Fons B.P. 62, F-69192 St-Fons Cédex (FR)**

## Description

La présente invention concerne des compositions photopolymérisables négatives, filmogènes, oléophiles et solubles dans les solvants organiques, comportant une résine époxy et un composé diazoïque photosensible, compositions applicables sur des supports appropriés tels que les supports de plaques lithographiques, le polyester traité, etc... La technique de l'impression lithographique, pour laquelle les compositions selon l'invention sont plus spécialement destinées, est basée sur le principe de la non-miscibilité des encres grasses et de l'eau et par la création sur un support de zones hydrophiles (retenant l'eau et repoussant l'encre grasse) et de zones encrophiles (retenant l'encre grasse et repoussant l'eau).

Après mouillage à l'eau de ce support, l'encre grasse appliquée sur toute la surface est retenue par les zones encrophiles et repoussée par les zones hydrophiles humidifiées.

Les couches photosensibles utilisables en lithographie sont de deux types:
– les couches dites positives avec lesquelles les zones non exposées à la lumière sont conservées comme zones image après développement,
– les couches dites négatives avec lesquelles les zones non exposées sont éliminées après développement.

Dans le cas des plaques lithographiques utilisant des compositions négatives telles que celles qui font l'objet de la présente invention, on expose ladite plaque à la lumière ultraviolette à travers un négatif ayant des zones transparentes et des zones opaques, de sorte que les zones non exposées sont facilement éliminées par un révélateur qui n'attaque pas les zones exposées, mettant ainsi à nu le support hydrophile sous-jacent.

Les zones exposées sont les zones «image» qui reçoivent l'encre grasse, tandis que les zones non exposées sont les zones «non-image».

A l'heure actuelle, la plupart des plaques lithographiques couramment employées en imprimerie, sont du type présensibilisées, c'est-à-dire revêtues d'une couche photosensible et prêtes à être insolées à travers un original à reproduire ayant un support transparent partiellement revêtu de zones opaques.

Lorsqu'on veut réaliser des plaques lithographiques telles que décrites ci-dessus, dans lesquelles les parties imprimantes sont obtenues par polymérisation d'une résine, on préfère généralement utiliser des résines ayant une ténacité et une dureté exceptionnelles afin de réaliser des plaques lithographiques permettant un très grand nombre de tirages. On sait que les résines époxy sont particulièrement bien adaptées dans ce but.

Il est connu du brevet américain n° 3 205 157 que certains sels de diazonium tels que les fluoborates d'aryl diazonium mélangés avec des résines époxy sont capables, sous l'action de la lumière, de libérer un acide de Lewis qui catalyse la réaction de polymérisation de la résine époxy sur elle-même. Dans ce but, les meilleurs résultats sont obtenus en utilisant de 1 à 10 parties de sel de diazonium pour 100 parties de résine époxy. Toutefois, de tels mélanges ne sont utilisables que pour la réalisation de circuits imprimés et, d'une façon générale, de vernis de protection, mais ils n'ont pas d'utilité dans le domaine des plaques lithographiques. En effet, ainsi qu'il est expliqué dans le brevet américain 3 708 296, de telles compositions photosensibles n'ont, après polymérisation, qu'une très faible réceptivité aux encres grasses, cette propriété étant évidemment critique dans le domaine des arts graphiques. De plus, de telles compositions présentent d'autres inconvénients tels qu'une durée de vie très courte due à l'instabilité chimique des sels de diazonium utilisés.

Le brevet américain 3 930 856 enseigne également que la présence d'un groupe amino dans le sel de diazonium doit être évitée si l'on veut catalyser la polymérisation des résines époxy car l'acide de Lewis libéré tend à se combiner avec ce groupe amino et aucun durcissement de la résine époxy n'est alors constaté.

La demande de brevet hollandaise 74/10806 décrit une composition photopolymérisable négative, filmogène pouvant contenir un fluoborate de p-diazodiphénylamine condensé formaldéhyde, et une résine époxy solide. Ces compositions sont difficiles à mettre en œuvre (irrégularité des revêtements) et n'apparaissent pas conduire à des plaques de qualité après insolation et développement (graissage...), et ceci notamment si le rapport diazo/résine époxy est faible.

Il se posait alors le problème de mettre au point une composition photopolymérisable négative, filmogène facilement mise en œuvre permettant d'obtenir des plaques lithographiques de bonne qualité (sans graissage) et dont le revêtement photopolymérisé présente une bonne réceptivité aux encres, une résistance mécanique accrue à l'usure. L'invention répond précisément à ce but.

Compte tenu de l'état de la technique mentionné ci-dessus, il a maintenant été trouvé, de façon inattendue, des compositions photopolymérisables comme indiquées dans la revendication 1 ayant une résistance mécanique exceptionnelle et possédant une excellente encrophilie les rendant aptes à la réalisation de plaques d'impression de très longue durée, c'est-à-dire permettant d'obtenir plus d'un million de tirages.

Les compositions photopolymérisables selon l'invention sont caractérisées en ce qu'elles sont constituées d'une part, de 30% à 70% en poids de fluoborate de paradiazodiphénylamine condensée avec un agent de condensation organique comportant des groupes carbonyles réactifs et, d'autre part, de 70% à 30% en poids d'une résine époxy monomère ou prépolymère, fluide à température ambiante, ayant un équivalent époxy inférieur à environ 350.

De telles compositions sont filmogènes, oléophiles et solubles dans les solvants organiques. Lorsqu'elles sont enduites sur un support, elles sont non collantes, non poisseuses après évaporation des solvants d'enduction malgré la présence de résine époxy liquide comme constituant de base. De plus, elles deviennent extrêmement dures et résistantes à l'usure après insolation aux rayonnements ultraviolets.

De préférence, les compositions photopolymérisables selon l'invention comporteront environ 50% de chacun des deux constituants susmentionnés. C'est en effet lorsque la proportion des deux constituants est voisine que la Demanderesse a obtenu les meilleurs résultats.

Lorsque les compositions décrites ci-dessus contiennent moins de 30% en poids de sel de diazonium, les couches correspondantes deviennent poisseuses et les supports revêtus de telles couches deviennent inutilisables: on constate un collage de la couche au négatif qui est ensuite définitivement endommagé, tandis que les zones développées de la plaque possèdent un voile. De plus, les plaques ne peuvent être stockées car le papier de protection dont elles sont recouvertes adhère à la surface. Par contre, lorsque les compositions comportent plus de 70% de sel de diazonium, les couches obtenues dans les zones exposées ne possèdent plus une dureté suffisante pour permettre de réaliser des couches ayant une bonne tenue aux révélateurs, c'est-à-dire, permettant un développement précis. De plus, après quelques mois de stockage, le développement devient long, incomplet et difficile, ce qui entraîne une perte de qualité de la plaque. Entre 40% et 60% de chacun des constituants, les résultats obtenus en lithographie sont particulièrement bons.

Les résines époxy utilisées dans le cadre de la présente invention, sont des résines fluides à température ambiante (la fluidité de la résine s'appréciant en l'absence de solvant) ayant un équivalent époxy inférieur à 350. La fluidité de telles résines époxy peut être définie comme dans le brevet américain n° 3 794 576. On utilisera de préférence, une résine époxy de viscosité supérieure à 5 Pa.s pour obtenir une couche non collante au toucher, en particulier pour réaliser des plaques lithographiques présensibilisées.

Une méthode qui peut être utilisée pour définir la limite de fluidité des résines selon l'invention est, par exemple, la méthode de Durran utilisant le mercure et dans laquelle on considère que le point de fusion d'une résine époxy est la température à laquelle la résine fondue atteint le sommet de mercure. Cette méthode est décrite en détails dans l'ouvrage «ANALYTICAL CHEMISTRY OF POLYMERS» – PART I – pages 155–156, aux éditions GOLDON M. FLINE-INTERSCIENCE PUBLISHERS INC NEW-YORK.

En réalisant cette méthode de mesure, on a constaté qu'il était préférable que les résines époxy utilisées dans la couche de la présente invention, aient un point de fusion inférieur ou égal à environ 38°C.

On constate toutefois que l'on n'obtient un développement facile avec une solution aqueuse acide additionnée de mouillant que pendant les quelques jours qui suivent l'enduction.

Lorsque le point de fusion, selon la méthode de Durran de la résine époxy utilisée, est inférieur ou égal à environ 27°C, le développement avec la solution aqueuse définie ci-dessus est possible pendant une dizaine de jours. Au-delà, l'action de cette solution est insuffisante et il est nécessaire d'ajouter à ladite solution de 5 à 10% de solvant de la couche. Ceci a pour résultat de réduire la qualité de l'image, les traits fins et les trames fines présentant des pertes de petits points.

Pour obtenir un bon développement avec la solution aqueuse ci-dessus, sans ajouter de solvant, et ce après plusieurs dizaines de jours ou de mois de stockage de la composition photosensible, ce qui est nécessaire dans le cas des plaques offset présensibilisées, la Demanderesse a constaté qu'il était préférable d'utiliser des résines époxy ayant un point de fusion Durran inférieur ou égal à environ 20°C.

Dans le cadre de la présente invention, les résines époxy qui sont susceptibles de convenir sont celles qui possèdent un équivalent époxy inférieur ou égal à 350. Par équivalent époxy, il faut entendre le poids en grammes de résine qui contient un équivalent-gramme d'époxy. De préférence, on utilisera des résines époxy ayant un équivalent époxy inférieur ou égal à 200, car plus l'équivalent époxy d'une résine est faible, plus le nombre de motifs époxy dans un gramme de résine est élevé et plus la couche obtenue est dure et permet un grand nombre de tirages.

D'une façon générale, on trouvera une description détaillée sur les résines époxy dans les pages 312 à 329 du premier volume supplémentaire de «ENCYCLOPEDIA OF CHEMICAL TECHNOLOGY», édité par KIRK and OTHMER et publié par INTERSCIENCE ENCYCLOPEDIA INC-NEW-YORK – 1957, ainsi qu'aux pages 340 à 528 du livre «Epoxy-Verbindungen und Epoxy-Harze», édité par PAQUIN et publié par SPRINGLER-VERLAG, BERLIN, GOTTINGEN und HEILDERBERG – 1958. Les résines époxy convenant plus particulièrement dans le cadre de l'invention, sont les éthers glycidiques du bisphénol A ainsi que les résines époxy novolaques phénol ou crésol. Parmi les éthers glycidiques du bisphénol A, la Demanderesse préfère utiliser les éthers diglycidiques du bisphénol A.

De telles résines fluides à température ambiante peuvent être utilisées seules ou en mélanges, de façon à ajuster éventuellement leur viscosité.

On peut par exemple, avantageusement dans certains cas particuliers, utiliser une résine époxy de viscosité inférieure à 5 Pa.s en mélange avec une résine époxy de viscosité supérieure et obtenir ainsi un mélange pouvant être utilisé dans le cadre de la présente invention. On peut de même utiliser des mélanges comportant au moins une résine de viscosité inférieure à 5 Pa.s et au moins une résine ayant un point de fusion Durran supérieur à 20°C, et obtenir un mélange convenant parfaitement. L'homme de l'art pourra ainsi réaliser toutes sortes de mélanges suivant le but recherché, lesdits mélanges étant compris dans le cadre de la présente invention. Pour plus de détails concernant les caractéristiques et mode de préparation des résines époxy, fluides, on pourra se reporter avantageusement au brevet US n° 3 794 576.

A titre non limitatif, les résines époxy fluides couramment disponibles dans le commerce et qui conviennent dans le cadre de la présente invention, sont:

– dans les produits vendus par la Société CIBA GEIGY sous la marque ARALDITE, les références GY 255, GY 260 ainsi que les références EPN 1138 et EPN 1139,

– dans les produits vendus par la Société SHELL sous les marques EPON ou EPIKOTE, les références 827, 828, 834, etc...

Les sels de diazonium utilisables dans le cadre de la présente invention, sont des fluoborates de paradiazodiphénylamine condensée avec un agent de condensation organique comportant des groupes carbonyles réactifs. De préférence, on choisira l'agent de condensation organique parmi les aldéhydes et les acétals et plus particulièrement parmi le formaldéhyde ou le paraformaldéhyde. On trouve couramment dans le commerce la paradiazodiphénylamine condensée avec le formaldéhyde: on peut citer à titre non limitatif les produits vendus sous la dénomination commerciale ZAL $BF_4$ (de la Société ABM Chemicals), P. 1001 $BF_4$ (de la Société Andrews Paper).

Les compositions photopolymérisables selon l'invention trouvent leur utilisation principale dans la réalisation de matériaux photosensibles constitués d'un support revêtu d'une couche photopolymérisable destinée à être exposée à la lumière actinique de façon à durcir les zones exposées tandis que les zones non exposées peuvent être enlevées à l'aide d'un révélateur. En particulier, l'utilisation de supports hydrophiles ou rendus hydrophiles pour un traitement quelconque bien connu de l'homme de l'art, permet la réalisation de plaques lithographiques, compte tenu des qualités d'oléophilie des compositions selon l'invention. Comme support hydrophile utilisable en lithographie, on peut citer de manière non limitative le chrome, l'aluminium, éventuellement anodisé, l'acier inoxydable, l'acier étamé, l'acier chromé, le polyester dont la surface a été rendue hydrophile, etc...

Les compositions photopolymérisables selon l'invention, adhèrent très bien sur ces supports hydrophiles. On peut même constater dans certains cas, une pénétration de la couche photosensible dans les microporosités desdits supports, ce qui peut entraîner dans certains cas un phénomène de graissage de la plaque, après développement, car la couche est alors difficilement extraite de ces microporosités. C'est pourquoi on fera de préférence subir au support hydrophile un traitement de surface destiné à boucher ces microporosités superficielles tout en donnant une excellente hydrophilie au support. Ce traitement de surface est bien connu de l'homme de l'art: il peut consister simplement à enduire le support à l'aide d'une solution aqueuse contenant environ 25% en poids de gomme arabique. L'excès de gomme est ensuite éliminé par lavage à l'eau:

seul un film extrêmement mince de gomme arabique est ainsi maintenu sur le support.

Un autre traitement bien connu de l'homme de l'art est le silicatage à chaud du support, plus particulièrement utilisé dans le traitement de supports en aluminium, anodisé ou non. Un tel traitement est décrit dans le brevet français n° 1 051 461. La solution utilisée est en général une solution à 2% de silicate de soude dont le rapport de la silice à la soude est compris entre 3,2 et 1. Le support en aluminium est plongé dans cette solution maintenue à une température comprise entre 82 °C et 100 °C.

Après rinçage à l'eau pour éliminer l'excès de silicate, il reste sur le support une très mince couche très solide, de silicate.

De même, un support en acier chromé est parfaitement hydrophile après un tel traitement.

La préparation des matériaux photosensibles selon l'invention s'effectuera de façon bien connue de l'homme de l'art en déposant de préférence 0,5 g/m² à 2 g/m² et plus particulièrement de 1 g/m² à 1,5 g/m².

Lorsqu'on dépose une couche trop faible de composition photopolymérisable (moins de 0,5 g/m²), il est en effet difficile d'obtenir une couche homogène et constante sur tout le support. Par contre, il n'est généralement pas nécessaire de déposer plus de 2 g/m² de couche photopolymérisable sur le support car on n'augmente que faiblement la résistance de ces couches après polymérisation mais leur développement devient difficile si l'on veut conserver une bonne finesse du trait.

Après insolation à travers un négatif semitransparent, les parties non insolées sont enlevées à l'aide d'un révélateur constitué par une solution aqueuse acide additionnée d'un agent mouillant. Ceci est une caractéristique très intéressante des plaques selon l'invention que d'être développables par des solutions aqueuses et non des solvants qui sont des agents polluants. Comme acide, on utilisera de préférence l'acide phosphorique, qui présente l'avantage de «préparer» le métal c'est-à-dire lui redonner ses propriétés hydrophiles, dans des proportions en poids par rapport au poids total de révélateur variant entre 5% et 40% et de préférence entre 10% et 30%. L'agent mouillant peut être un agent mouillant quelconque, qu'il soit anionique, cationique ou non ionique. Il constitue de 2% à 30% et de préférence de 5% à 20% en poids de la solution de développement.

On peut citer notamment le lauryl sulfate de sodium, etc...

Parmi les produits commerciaux, on peut citer notamment:

– l'AMONYL 250 BA ou 380 BA (de la Société SEPPIC),

– le SIMULSOL 1030 NP (de la Société SEPPIC),

–le MELANOL LP 20 T, CL 40 V 90 ou CL 90 (de la Société SEPPIC),

– le BACFORD AD ou BL 80 (de la Société BACFORD),

– le DEHYTON AD 30 ⎫ (de la Société DEUTSCHE
– le DEHYDOL 25 ⎬ HYDRIERWERKE, GMBH)

– le SOPROPHOR TPH (de la Société SOPRO-SOIE),
– le P3VR 3153/3 (de la Société HENKEL).

On peut améliorer encore les qualités du révélateur en ajoutant à celui-ci environ 1% en poids d'alcool benzylique.

Les couches photopolymérisables selon l'invention possèdent la propriété, après insolation aux rayons ultraviolets, d'être extrêmement dures et résistantes aux solvants y compris la diméthylformamide.

L'invention sera mieux comprise à l'aide des exemples de réalisation suivants, donnés à titre non limitatif:

Exemple 1

Sur un support en acier chromé traité avec une solution de gomme arabique, dégommé par rinçage à l'eau, puis séché, on enduit à la tournette (50 t/min) pendant 30 secondes la solution suivante:

| | | |
|---|---|---|
| résine époxy novolaque 1139 (CIBA-GEIGY) (équivalent époxy: 172 à 179 – viscosité à 52 °C: 1,7 Pa.s – point de fusion Durran: 18 °C) | 1 | g |
| Fluoborate de paradiazodiphényl amine condensée avec le formaldéhyde ZAL BF$^4$ (Société ABM) | 1 | g |
| rouge de méthyle | 0,04 | g |
| diméthylformamide | 60 | g |
| isopropanol | 19 | g |
| butanol primaire | 19 | g |

La plaque ainsi enduite est ensuite séchée dans la tournette pendant 5 minutes à 40 °C, puis dans une étuve à 85 °C pendant 5 minutes.

Après insolation à travers un négatif pendant 2 minutes sur un châssis NU-ARC de 2 KW, on observe une image visible due à la présence du rouge de méthyle. L'image est ensuite développée par action mécanique d'un tampon, pendant 1 minute à 1 minute 30 secondes, imbibé d'une solution aqueuse contenant 12% en poids d'acide phosphorique et 5% en poids d'agent mouillant cationique amphotère du type AMONYL 380 BA. Les parties non insolées de la couche se dissolvent.

(On obtient les mêmes résultats avec une solution aqueuse contenant 20% d'acide phosphorique et 5% en poids d'agent mouillant non ionique Nonyl phénol tel que le SIMULSOL 1030 NP ou encore à l'aide d'une solution aqueuse contenant 25% en poids d'acide phosphorique et 5% en poids d'agent mouillant anionique lauryl sulfate du type MELANOL CL 30 ou CL 90).

En utilisant comme négatifs les différentes gammes tramées du commerce, on obtient les résultats suivants:

– Avec la gamme UGRA (qui représente les différentes plages tramées des trames offset de 60 lignes et 120 lignes/2,54 cm, la gamme comportant 12 plages reproduisant tous les points de 4% à 96% de surface couverte), tous les points sont reproduits, y compris les points les plus fins de la trame 120 lignes/cm.

– Avec la gamme FOGRA (qui permet de mesurer avec précision le pouvoir de résolution de la plaque, car elle comporte des lignes en positif et en réserve (négatif) dont les épaisseurs sont mesurées en microns: 4, 6, 8, 10, etc ...), les traits positifs de 4 microns et les traits négatifs en réserve de 6 microns sont parfaitement nets. La plaque calée sur machine a permis d'obtenir plus de 1 million de tirages sans usure apparente de la couche, ce qui est tout à fait remarquable. De plus, la plaque après développement, possède une excellente tenue aux solvants: on ne constate aucune altération de l'image après immersion de la plaque pendant 15 minutes dans l'alcool éthylique, l'éthylglycol, l'acétate de méthylglycol ou dans le diméthylformamide.

Exemple 2

Sur le même support que dans l'exemple 1, on enduit à la tournette (50 t/mn) pendant 30 secondes, la solution suivante:

| | | |
|---|---|---|
| diméthylformamide | 60 | g |
| butanol primaire | 35 | g |
| résine époxynovolaque 1139 (CIBA GEIGY) | 3 | g |
| fluoborate de paradiazodiphénylamine condensé formaldéhyde ZAL BF$_4$ (Société ABM) | 2 | g |

Après séchage dans la tournette pendant 5 minutes à 40 °C, puis dans une étuve pendant 5 minutes à 85 °C, la plaque est insolée à travers un négatif pendant 2 minutes sur un châssis NU-ARC de 2 KW, à une distance de 60 cm de la lampe ultraviolette.

Les parties insolées se colorent en bleu: on obtient ainsi une image visible en lumière blanche et en éclairage inactinique.

L'image est ensuite développée comme dans l'exemple 1 avec une solution aqueuse contenant 12% en poids d'acide phosphorique et 5% en poids d'agent mouillant cationique amphotère du type AMONYL 380 BA.

On obtient les mêmes résultats du point de vue finesse du trait, tenue aux solvants et nombre de tirages que dans l'exemple 1.

On obtient également les mêmes résultats en développant la plaque à l'aide d'une solution aqueuse contenant 20% d'acide phosphorique et 5% d'agent mouillant non ionique Nonylphénol (SIMULSOL 1030 NP) ainsi qu'avec une solution de développement contenant 25% d'acide phosphorique et 5% d'agent mouillant anionique lauryl sulfate (MELANOL CL 30 ou CL 90).

Exemple 3

On enduit dans les mêmes conditions que dans l'exemple 1 un support d'acier chromé, traité avec du polyacrylamide, à l'aide de la solution suivante:

| | | |
|---|---|---|
| résine époxy novolaque 1139 (CIBA-GEIGY) | 1,5 | g |
| Fluoborate de paradiazodiphénylamine condensé avec le formaldéhyde ZAL BF$_4$ (Société ABM) | 2,5 | g |
| diméthylformamide | 60 | g |
| isopropanol | 18 | g |
| butanol primaire | 18 | g |

La plaque ainsi obtenue est ensuite insolée et développée dans les mêmes conditions que dans l'exemple 1, avec les mêmes révélateurs. On obtient les mêmes résultats du point de vue finesse de trait, tenue aux solvants et nombre de tirages.

Exemple 4

On réalise l'enduction d'un support identique et dans les mêmes conditions que dans l'exemple 1 à l'aide de la solution suivante:

Résine époxy ARALDITE GY 260 (CIBA-GEIGY)
(équivalent époxy compris entre 185 et 196 –
viscosité à 25 °C de 12 à 16 Pa.s –
point de fusion Durran de 10 °C)     3 g

Fluoborate de paradiazodiphénylamine
condensé avec le formaldéhyde
(ZAL BF$_4$ de la Sté ABM)     2 g

Diméthylformamide     45 g

Acétate de méthylglycol     50 g

Après insolation dans les mêmes conditions que dans l'exemple 1, on développe la plaque obtenue à l'aide d'une solution aqueuse contenant 12% d'acide phosphorique et 5% d'agent mouillant du type laurylsulfate (MELANOL LP 20 T de la Société SEPPIC). On obtient les mêmes résultats que dans l'exemple 1, tant du point de vue qualité de développement et tenue aux solvants que du point de vue longévité de la plaque.

On obtient également les mêmes résultats avec une solution de développement contenant 20% d'acide phosphorique et 5% d'agent mouillant.

Exemple 5

On réalise une plaque lithographique dans des conditions identiques à celles de l'exemple 4 en remplaçant la résine ARALDITE GY 260 par la même quantité de résine ARALIDITE GY 255 (CIBA-GEIGY) équivalent époxy compris entre 180 et 200 – viscosité à 25 °C comprise entre 5 et 6 Pa.s – point de fusion Durran de 5 °C).

On obtient les mêmes résultats que dans l'exemple 1.

Exemple 6

On réalise une plaque lithographique dans des conditions identiques à celles de l'exemple 4 en remplaçant la résine ARALDITE GY 260 par la même quantité de résine EPIKOTE 828 (SHELL CHEMICALS) (équivalent époxy compris entre 184 et 194 – viscosité à 25 °C comprise entre 10 et 15 Pa.s et point de fusion Durran de 10 °C).

On obtient les mêmes résultats que dans l'exemple 1.

Exemple 7

On réalise une plaque lithographique dans des conditions identiques à celles de l'exemple 1. On soumet la plaque obtenue à une épreuve de vieillissement accéléré en étuve à 60 °C pendant 24 heures.

Après insolation comme dans l'exemple 1, la plaque est développée à l'aide de la solution suivante:

12% en poids d'acide phosphorique à 85%,
5% en poids d'agent mouillant P3VR3153/3 de la Société HENKEL,
83% en poids d'eau déminéralisée.

On obtient une copie de qualité tout à fait remarquable du point de vue de la finesse de traits.

Exemple 8

Sur le même support que dans l'exemple 1, on enduit à la tournette la solution suivante:

diméthylacétamide     60 g

n-butanol     10 g

isopropanol     10 g

fluoborate de paradiazodiphénylamine
condensé formaldéhyde ZAL BF$_4$     2 g

résine EBECRYL 600 de la Sté UCB     2 g

rouge de méthyle     0,037 g

La résine EBECRYL 600 est une résine époxy-acrylique dont la viscosité est comprise entre 4 et 8 Pa.s à 60 °C. Son point de fusion Durran est inférieur à la température ambiante, soit 18 °C.

Après séchage en tournette puis 5' à 85 °C en étuve, la plaque est insolée comme les exemples précédents. Les parties non exposées sont éliminées à l'aide d'une solution aqueuse contenant 20% d'acide phosphorique et 5% de l'agent mouillant P3 VR 3153/3 de la Société HENKEL. Le développement est très rapide et nécessite moins de 30''.

Après un vieillissement accéléré de 24 h à 60 °C de la plaque enduite avant copie, on obtient les mêmes résultats.

Exemple 9

Sur un support classique d'aluminium grainé et anodisé de la Société SATMA, on enduit à la tournette suivant le mode opératoire de l'exemple 8, la solution suivante:

diméthylacétamide     60 g

n-butanol     10 g

isopropanol     10 g

fluoborate de paradiazodiphénylamine
condensé ZAL BF$_4$     2 g

résine EBECRYL 860     2 g

rouge de méthyle     0,037 g

La résine EBECRYL 860 de la Société UCB est un acrylate d'huile de soja époxydée. Sa viscosité est d'environ 25 Pa.s à 25 °C. Son point de fusion Durran est inférieur à 18 °C.

La plaque ainsi obtenue se comporte à l'insolation et au développement comme la plaque de l'exemple précédent. Toutefois, il est préférable de modifier le révélateur en réduisant la quantité d'acide phosphorique.

**Revendications pour les Etats contractants: BE, CH, DE, FR, GB, IT, LI, LU, NL, SE**

1. Composition photopolymérisable négative filmogène, oléophile soluble dans les solvants organiques et contenant:

– un fluoborate de para-diazodiphénylamine condensé avec un agent de condensation organique comportant des groupes carbonyle réactifs (constituant a)

– et une résine filmogène pratiquement insoluble dans l'eau et constituée par une résine époxy (constituant b),

caractérisée en ce que la résine époxyde est une résine époxy monomère ou prépolymère fluide à température ambiante, ayant un équivalent époxy inférieur à 350 et en ce que la composition comporte de 30 à 70% en poids de fluoborate et 70 à 30% de résine époxy.

2. Composition photopolymérisable selon la revendication 1, caractérisée en ce qu'elle comporte de 40% à 60% du constituant (a) et 60% à 40% du constituant (b).

3. Composition selon la revendication 1 ou 2, caractérisée en ce qu'elle comporte sensiblement la même quantité des deux constituants (a) et (b).

4. Composition photopolymérisable selon l'une des revendications 1 à 3, caractérisée en ce que l'agent de condensation organique est un aldéhyde ou un acétal.

5. Composition photopolymérisable selon l'une des revendications 1 à 4, caractérisée en ce que l'agent de condensation organique est le formaldéhyde ou le paraformaldéhyde.

6. Composition photopolymérisable selon l'une des revendications 1 à 5, caractérisée en ce que la résine époxy a un équivalent époxy inférieur ou égal à 200.

7. Composition photopolymérisable selon l'une des revendications 1 à 6, caractérisée en ce que la résine époxy a un point de fusion Durran inférieur ou égal à 38 °C.

8. Composition photopolymérisable selon l'une des revendications 1 à 7, caractérisée en ce que la résine époxy a un point de fusion Durran inférieur ou égal à 27 °C.

9. Composition photopolymérisable selon l'une des revendications 1 à 8, caractérisée en ce que la résine a un point de fusion Durran inférieur ou égal à 20 °C.

10. Composition photopolymérisable selon l'une des revendications 1 à 9, caractérisée en ce que la résine époxy a une viscosité supérieure ou égale à 5 Pa.s à 25 °C.

11. Composition photopolymérisable selon l'une des revendications 1 à 10, caractérisée en ce que la résine époxy est choisie parmi les éthers glycidiques du bisphénol A et/ou les résines époxy novolaques phénol ou crésol, utilisées seules ou en mélanges.

12. Composition photopolymérisable selon l'une des revendications 1 à 11, caractérisée en ce que la résine époxy est choisie parmi les éthers diglycidiques du bisphénol A.

13. Composition selon l'une des revendications 1 à 12, caractérisée en ce que la résine époxy est une résine époxy acrylate.

14. Matériau photosensible constitué d'un support revêtu d'une couche photopolymérisable destinée à être exposée à la lumière actinique de façon à durcir les zones exposées, tandis que les zones non exposées peuvent être enlevées à l'aide d'un révélateur, caractérisé en ce que la couche photopolymérisable est composée d'une composition conforme à l'une des revendications 1 à 13.

15. Matériau photosensible selon la revendication 14, caractérisé en ce que le poids de la couche photosensible déposé sur le support est compris entre 0,5 g/m² et 2 g/m².

16. Matériau photosensible selon la revendication 14, caractérisé en ce que le poids de la couche photosensible déposé sur le support est compris entre 1 g/m² et 1,5 g/m².

17. Matériau photosensible selon l'une des revendications 14 à 16, caractérisé en ce que le support est hydrophile, ledit matériau étant destiné à l'impression lithographique.

18. Matériau photosensible selon l'une des revendications 14 à 17, caractérisé en ce que le support est en acier chromé.

**Revendications pour l'Etat contractant: AT**

1. Utilisation comme couche photosensible, notamment pour plaques d'impression, d'une composition photopolymérisable négative filmogène, oléophile, soluble dans les solvants organiques, et contenant:

– un fluoborate de para-diazodiphénylamine condensé avec un agent de condensation organique comportant des groupes carbonyle réactifs (constituant a)

– et une résine filmogène pratiquement insoluble dans l'eau et constituée par une résine époxy (constituant b),

caractérisée en ce que la résine époxyde est une résine époxy monomère ou prépolymère fluide à température ambiante, ayant un équivalent époxy inférieur à 350 et en ce que la composition comporte de 30 à 70% en poids de fluoborate et 70 à 30% de résine époxy.

2. Utilisation selon la revendication 1 dans laquelle la composition photopolymérisable comporte de 40% à 60% du constituant (a) et 60% à 40% du constituant (b).

3. Utilisation selon la revendication 1 ou 2 dans laquelle la composition comporte sensiblement la même quantité des deux constituants (a) et (b).

4. Utilisation selon l'une des revendications 1 à 3, dans laquelle l'agent de condensation organique est un aldéhyde ou un acétal.

5. Utilisation selon l'une des revendications 1 à 4, dans laquelle l'agent de condensation organique est le formaldéhyde ou le paraformaldéhyde.

6. Utilisation selon l'une des revendications 1 à 5, dans laquelle la résine époxy de la composition a un équivalent époxy inférieur ou égal à 200.

7. Utilisation selon l'une des revendications 1 à 6, dans laquelle la résine époxy de la composition a un point de fusion Durran inférieur ou égal à 38 °C.

8. Utilisation selon l'une des revendications 1 à 7, dans laquelle la résine époxy de la composition a un point de fusion Durran inférieur ou égal à 27 °C.

9. Utilisation selon l'une des revendications 1 à 8, dans laquelle la résine de la composition a un point de fusion Durran inférieur ou égal à 20 °C.

10. Utilisation selon l'une des revendications 1 à 9, dans laquelle la résine époxy de la composition a une viscosité supérieure ou égale à 5 Pa.s à 25 °C.

11. Utilisation selon l'une des revendications 1 à 10, dans laquelle la résine époxy de la composition est choisie parmi les éthers glycidiques du bisphénol A et/ou les résines époxy novolaques phénol ou crésol, utilisées seules ou en mélanges.

12. Utilisation selon l'une des revendications 1 à 11, dans laquelle la résine époxy de la composition est choisie parmi les éthers diglycidiques du bisphénol A.

13. Utilisation selon l'une des revendications 1 à 12, dans laquelle la résine époxy de la composition est une résine époxy acrylate.

14. Matériau photosensible constitué d'un support revêtu d'une couche photopolymérisable destinée à être exposée à la lumière actinique de façon à durcir les zones exposées, tandis que les zones non exposées peuvent être enlevées à l'aide d'un révélateur, caractérisé en ce que la couche photopolymérisable est du type de celle mise en œuvre selon l'une des revendications 1 à 13.

15. Matériau photosensible selon la revendication 14, caractérisé en ce que le poids de la couche photosensible déposé sur le support est compris entre 0,5 g/m² et 2 g/m².

16. Matériau photosensible selon la revendication 15, caractérisé en ce que le poids de la couche photosensible déposé sur le support est compris entre 1 g/m² et 1,5 g/m².

17. Matériau photosensible selon l'une des revendications 14 à 16, caractérisé en ce que le support est hydrophile, ledit matériau étant destiné à l'impression lithographique.

18. Matériau photosensible selon l'une des revendications 14 à 17 caractérisé en ce que le support est en acier chromé.

**Claims for the Contracting States: BE, CH, DE, FR, GB, IT, LI, LU, NL, SE**

1. Negative, film-forming, oleophilic, photopolymerizable composition, soluble in organic solvents and containing:
   - a para-diazodiphenylamine fluoroborate condensed with an organic condensation agent incorporating reactive carbonyl groups (component a)
   - and a practically water-insoluble, film-forming resin consisting of an epoxy resin (component b), characterised in that the epoxide resin is a monomeric or prepolymer epoxy resin which is fluid at ambient temperature, and which has an epoxy equivalent of less than 350 and in that the composition incorporates from 30 to 70% by weight of fluoroborate and 70 to 30% of epoxy resin.

2. Photopolymerizable composition according to Claim 1, characterised in that it incorporates from 40% to 60% of component (a) and 60% to 40% of component (b).

3. Composition according to Claim 1 or 2, characterised in that it incorporates substantially the same quantity of the two components (a) and (b).

4. Photopolymerizable composition according to one of Claims 1 to 3, characterised in that the organic condensation agent is an aldehyde or an acetal.

5. Photopolymerizable composition according to one of Claims 1 to 4, characterised in that the organic condensation agent is formaldehyde or paraformaldehyde.

6. Photopolymerizable composition according to one of Claims 1 to 5, characterised in that the epoxy resin has an epoxy equivalent of less than or equal to 200.

7. Photopolymerizable composition according to one of Claims 1 to 6, characterised in that the epoxy resin has a Durran melting point below or equal to 38 °C.

8. Photopolymerizable composition according to one of Claims 1 to 7, characterised in that the epoxy resin has a Durran melting point below or equal to 27 °C.

9. Photopolymerizable composition according to one of Claims 1 to 8, characterised in that the resin has a Durran melting point below or equal to 20 °C.

10. Photopolymerizable composition according to one of Claims 1 to 9, characterised in that the epoxy resin has a viscosity greter than or equal to 5 Pa s at 25 °C.

11. Photopolymerizable composition according to one of Claims 1 to 10, characterised in that the epoxy resin is chosen from bisphenol A glycidyl ethers an/or phenol or cresol novolak epoxy resins, which are employed alone or as mixtures.

12. Photopolymerizable composition according to one of Claims 1 to 11, characterised in that the epoxy resin is chosen from bisphenol A diglycidyl ethers.

13. Composition according to one of Claims 1 to 12, characterised in that the epoxy resin is an epoxy acrylate resin.

14. Photosensitive material consisting of a substrate coated with a photopolymerizable layer intended to be exposed to actinic light so as to harden the exposed areas, while the unexposed areas can be removed by the use of a developer, characterised in that the photopolymerizable layer consists of a composition according to one of Claims 1 to 13.

15. Photosensitive material according to Claim 14, characterised in that the weight of the photosensitive layer deposited on the substrate is between 0.5 g/m² and 2 g/m².

16. Photosensitive material according to Claim 14, characterised in that the weight of the photosensitive layer deposited on the substrate is between 1 g/m² and 1.5 g/m².

17. Photosensitive material according to one of Claims 14 to 16, characterised in that the substrate is hydrophilic, the said material being intended for lithographic printing.

18. Photosensitive material according to one of Claims 14 to 17, characterised in that the substrate is made of chrome steel.

## Claims for the Contracting State: AT

1. Use as a photosensitive layer, especially for printing plates, of a negative, film-forming, oleophilic, photopolymerizable composition, soluble in organic solvents, and containing:
   - a para-diazodiphenylene fluoroborate condensed with an organic condensation agent incorporating reactive carbonyl groups (component a)
   - and a practically water-insoluble, film-forming resin consisting of an epoxy resin (component b), characterised in that the epoxy resin is a monomeric or prepolymer epoxy resin which is fluid at ambient temperature and has an epoxy equivalent of less than 350 and in that the composition incorporates from 30 to 70% by weight of fluoroborate and 70 to 30% of epoxy resin.

2. Use according to Claim 1, in which the photopolymerizable composition incorporates from 40% to 60% of component (a) and 60% to 40% of component (b).

3. Use according to Claim 1 or 2, in which the composition incorporates substantially the same quantity of the two components (a) and (b).

4. Use according to one of Claims 1 to 3, in which the organic condensation agent is an aldehyde or an acetal.

5. Use according to one of Claims 1 to 4, in which the organic condensation agent is formaldehyde or paraformaldehyde.

6. Use according to one of Claims 1 to 5, in which the epoxy resin in the composition has an epoxy equivalent of less than or equal to 200.

7. Use according to one of Claims 1 to 6, in which the epoxy resin of the composition has a Durran melting point below or equal to 38 °C.

8. Use according to one of Claims 1 to 7, in which the epoxy resin in the composition has a Durran melting point below or equal to 27 °C.

9. Use according to one of Claims 1 to 8, in which the resin in the composition has a Durran melting point below or equal to 20 °C.

10. Use according to one of Claims 1 to 9, in which the epoxy resin in the composition has a viscosity greater than or equal to 5 Pa s at 25 °C.

11. Use according to one of Claims 1 to 10, in which the epoxy resin in the composition is chosen from bisphenol A glycidyl ethers and/or phenol or cresol novolak epoxy resins, which are employed alone or as mixtures.

12. Use according to one of Claims 1 to 11, in which the epoxy resin in the composition is chosen from bisphenol A diglycidyl ethers.

13. Use according to one of Claims 1 to 12, in which the epoxy resin in the composition is an epoxy acrylate resin.

14. Photosensitive material consisting of a substrate coated with a photopolymerizable layer intended to be exposed to actinic light so as to harden the exposed areas, while the unexposed areas can be removed by the use of a developer, characterised in that the photopolymerizable layer consists of a composition according to one of Claims 1 to 13.

15. Photosensitive material according to Claim 14, characterised in that the weight of the photosensitive layer deposited on the substrate is between 0.5 g/m² and 2 g/m².

16. Photosensitive material according to Claim 15, characterised in that the weight of the photosensitive layer deposited on the substrate is between 1 g/m² and 1.5 g/m².

17. Photosensitive material according to one of Claims 14 to 16, characterised in that the substrate is hydrophilic, the said material being intended for lithographic printing.

18. Photosensitive material according to one of Claims 14 to 17, characterised in that the substrate is made of chrome steel.

## Patentansprüche für die Vertragsstaaten: BE, CH, DE, FR, GB, IT, LI, LU, NL, SE

1. Photopolymerisierbares, negativ filmbildendes, oleophiles Gemisch, löslich in organischen Lösungsmitteln und enthaltend
   - ein Fluoroborat von p-Diazodiphenylamin, kondensiert mit einem organischen Kondensationsmittel, das reaktionsfähige Carbonylgruppen trägt (Bestandteil a)
   - und ein filmbildendes, in Wasser praktisch unlösliches Harz, das durch ein Epoxidharz dargestellt wird (Bestandteil b), dadurch gekennzeichnet, dass das Epoxidharz ein bei Umgebungstemperatur flüssiges Epoxidharzmonomer oder -präpolymer ist, das ein Epoxidäquivalent von unter 350 aufweist, und dass das Gemisch 30 bis 70 Gew.-% Fluoroborat und 70 bis 30 Gew.-% Epoxidharz enthält.

2. Photopolymerisierbares Gemisch nach Anspruch 1, dadurch gekennzeichnet, dass es 40 bis 60% des Bestandteils (a) und 60 bis 40% des Bestandteils (b) enthält.

3. Photopolymerisierbares Gemisch nach Anspruch 1 oder 2, dadurch gekennzeichnet, dass es genau die gleiche Menge der zwei Bestandteile (a) und (b) enthält.

4. Photopolymerisierbares Gemisch nach einem der Ansprüche 1 bis 3, dadurch gekennzeichnet, dass das organische Kondensationsmittel ein Aldehyd oder ein Acetal ist.

5. Photopolymerisierbares Gemisch nach einem der Ansprüche 1 bis 4, dadurch gekennzeichnet, dass das organische Kondensationsmittel Formaldehyd oder Paraformaldehyd ist.

6. Photopolymerisierbares Gemisch nach einem der Ansprüche 1 bis 5, dadurch gekennzeichnet, dass das Epoxidharz ein Epoxidäquivalent von 200 oder weniger aufweist.

7. Photopolymerisierbares Gemisch nach einem der Ansprüche 1 bis 6, dadurch gekennzeichnet, dass das Epoxidharz einen Durran-Schmelzpunkt von 38 °C oder darunter aufweist.

8. Photopolymerisierbares Gemisch nach einem der Ansprüche 1 bis 7, dadurch gekennzeichnet, dass das Epoxidharz einen Durran-Schmelzpunkt von 27 °C oder darunter aufweist.

9. Photopolymerisierbares Gemisch nach einem der Ansprüche 1 bis 8, dadurch gekennzeichnet, dass das Harz einen Durran-Schmelzpunkt von 20 °C oder darunter aufweist.

10. Photopolymerisierbares Gemisch nach einem der Ansprüche 1 bis 9, dadurch gekennzeichnet, dass das Epoxidharz bei 25 °C eine Viskosität von 5 Pa·s oder darüber aufweist.

11. Photopolymerisierbares Gemisch nach einem der Ansprüche 1 bis 10, dadurch gekennzeichnet, dass das Epoxidharz ausgewählt ist aus den Glycidyläthern von Bisphenol A und/oder den Phenol- oder Kresolnovolakepoxidharzen, die jeweils allein oder im Gemisch verwendet werden.

12. Photopolymerisierbares Gemisch nach einem der Ansprüche 1 bis 11, dadurch gekennzeichnet, dass das Epoxidharz aus den Diglycidyläthern von Bisphenol A ausgewählt ist.

13. Photopolymerisierbares Gemisch nach einem der Ansprüche 1 bis 12, dadurch gekennzeichnet, dass das Epoxidharz ein Epoxyacrylatharz ist.

14. Photoempfindliches Material, bestehend aus einem Träger, der mit einer photopolymerisierbaren Schicht überzogen ist, die dazu bestimmt ist, actinischem Licht ausgesetzt zu werden, so dass die ausgesetzten Zonen härten, während die nicht ausgesetzten Zonen mit Hilfe eines Entwicklers entfernt werden können, dadurch gekennzeichnet, dass die photopolymerisierbare Schicht aus einem Gemisch gemäss einem der Ansprüche 1 bis 13 zusammengesetzt ist.

15. Photoempfindliches Material nach Anspruch 14, dadurch gekennzeichnet, dass das Gewicht der auf den Träger aufgebrachten photoempfindlichen Schicht zwischen 0,5 und 2 g/m² liegt.

16. Photoempfindliches Material nach Anspruch 14, dadurch gekennzeichnet, dass das Gewicht der auf den Träger aufgebrachten photoempfindlichen Schicht zwischen 1 und 1,5 g/m² liegt.

17. Photoempfindliches Material nach einem der Ansprüche 14 bis 16, dadurch gekennzeichnet, dass der Träger hydrophil ist und das genannte Material für Lithographiedruck bestimmt ist.

18. Photoempfindliches Material nach einem der Ansprüche 14 bis 17, dadurch gekennzeichnet, dass der Träger aus Chromstahl besteht.

**Patentansprüche für den Vertragsstaat: AT**

1. Verwendung als photoempfindliche Schicht, insbesondere für Druckplatten, eine photopolymerisierbaren, negativ filmbildenden, oleophilen Gemisches, löslich in organischen Lösungsmitteln und enthaltend
— ein Fluoroborat von p-Diazodiphenylamin, kondensiert mit einem organischen Kondensationsmittel, das reaktionsfähige Carbonylgruppen trägt (Bestandteil a)
— und ein filmbildendes, in Wasser praktisch unlösliches Harz, das durch ein Epoxidharz dargestellt wird (Bestandteil b),
dadurch gekennzeichnet, dass das Epoxidharz ein bei Umgebungstemperatur flüssiges Epoxidharzmonomer oder -prepolymer ist, das ein Epoxidäquivalent von unter 350 aufweist, und dass das Gemisch 30 bis 70 Gew. -% Fluoroborat und 70 bis 30 Gew.-% Epoxidharz enthält.

2. Verwendung nach Anspruch 1, worin das photopolymerisierbare Gemisch 40 bis 60% des Bestandteils (a) und 60 bis 40% des Bestandteils (b) enthält.

3. Verwendung nach Anspruch 1 oder 2, worin das Gemisch genau die gleiche Menge der zwei Bestandteile (a) und (b) enthält.

4. Verwendung nach einem der Ansprüche 1 bis 3, worin das organische Kondensationsmittel ein Aldehyd oder ein Acetal ist.

5. Verwendung nach einem der Ansprüche 1 bis 4, worin das organische Kondensationsmittel Formaldehyd oder Paraformaldehyd ist.

6. Verwendung nach einem der Ansprüche 1 bis 5, worin das Epoxidharz des Gemisches ein Epoxidäquivalent von 200 oder darunter aufweist.

7. Verwendung nach einem der Ansprüche 1 bis 6, worin das Epoxidharz des Gemisches einen Durran-Schmelzpunkt von 38 °C oder darunter aufweist.

8. Verwendung nach einem der Ansprüche 1 bis 7, worin das Epoxidharz des Gemisches einen Durran-Schmelzpunkt von 27 °C oder darunter aufweist.

9. Verwendung nach einem der Ansprüche 1 bis 8, worin das Harz des Gemisches einen Durran-Schmelzpunkt von 20 °C oder darunter aufweist.

10. Verwendung nach einem der Ansprüche 1 bis 9, worin das Epoxidharz des Gemisches bei 25 °C eine Viskosität von 5 Pa·s oder darüber aufweist.

11. Verwendung nach einem der Ansprüche 1 bis 10, worin das Epoxidharz des Gemisches ausgewählt ist aus den Glycidyläthern von Bisphenol A und/oder den Phenol- oder Kresolnovolakepoxidharzen, die allein oder in Gemischen eingesetzt werden.

12. Verwendung nach einem der Ansprüche 1 bis 11, worin das Epoxidharz des Gemisches aus den Diglycidyläthern von Bisphenol A ausgewählt ist.

13. Verwendung nach einem der Ansprüche 1 bis 12, worin das Epoxidharz des Gemisches ein Epoxyacrylatharz ist.

14. Photoempfindliches Material, bestehend aus einem Träger, der mit einer photopolymerisierbaren Schicht überzogen ist, die dazu bestimmt ist, actinischem Licht ausgesetzt zu werden, um die so ausgesetzten Zonen zu härten, während die nicht ausgesetzten Zonen mit Hilfe eines Entwicklers entfernt werden können, dadurch gekennzeichnet, dass die photopolymerisierbare Schicht derart ist, wie sie gemäss einem der Ansprüche 1 bis 13 verwendet wird.

15. Photoempfindliches Material nach Anspruch 14, dadurch gekennzeichnet, dass das Gewicht der auf den Träger aufgebrachten photoempfindlichen Schicht zwischen 0,5 und 2 g/m² liegt.

16. Photoempfindliches Material nach Anspruch 15, dadurch gekennzeichnet, dass das Gewicht der auf den Träger aufgebrachten photoempfindlichen Schicht zwischen 1 und 1,5 g/m² liegt.

17. Photoempfindliches Material nach einem der Ansprüche 14 bis 16, dadurch gekennzeichnet, dass der Träger hydrophil ist und das genannte Material für Lithographiedruck bestimmt ist.

18. Photoempfindliches Material nach einem der Ansprüche 14 bis 17, dadurch gekennzeichnet, dass der Träger aus Chromstahl ist.